# EUROPEAN PATENT SPECIFICATION

(11) **EP 2 846 432 B1**
(45) Date of publication and mention of the grant of the patent: **06.04.2016**
(21) Application number: 14183023.2
(22) Date of filing: 01.09.2014
(51) Int. Cl.: H02H 3/16, G01R 31/02, H02H 3/33

(54) **Residual current detection method and device**
Reststromdetektionsverfahren und -vorrichtung
Procédé de détection de courant résiduel et dispositif

(30) Priority: 05.09.2013 CN 201310401158
(43) Date of publication of application: 11.03.2015
(73) Proprietor: Siemens Aktiengesellschaft, 80333 München (DE)
(72) Inventor: Huang, Xian, 200030 Shanghai (CN); Wu, Di, 200122 Shanghai (CN)
(74) Representative: Patentanwaltskanzlei WILHELM & BECK

(56) References cited:
- EP-A2- 2 395 363
- US-A1- 2012 319 699

## Description

The present invention relates to a residual current detection method and device, and further to a residual current protection device having the residual current detection device.

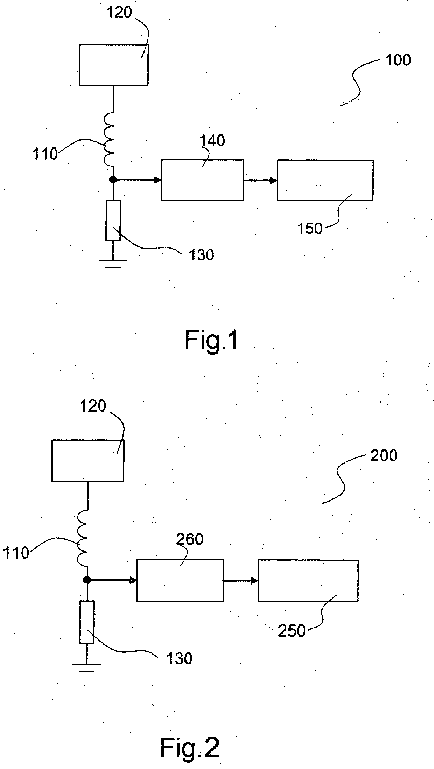

Fig. 1 shows by way of example a typical residual current detection device. As Fig. 1 shows, the residual current detection device 100 comprises: an inductor 110, an excitation signal generating circuit 120, a sampling resistor 130, a filter circuit 140 and a processing unit 150.

In Fig. 1, the inductor 110 represents a winding of a current transformer, with one end connected to the excitation signal generating circuit 120, and the other end connected to a sampling resistor 130. The current transformer comprises an iron core and windings, the function thereof being to sense whether a residual current, also called a leakage current, is present on a power supply line (not shown in the figure).

In the example shown in Fig. 1, the sampling resistor 130 is a resistor connected in series with the inductor 110 (i.e. with the current transformer), the other end of the sampling resistor being connected to ground (GND). Thus, in the example shown in Fig. 1, the current flowing through the sampling resistor comprises not only a residual current which might arise on the power supply line, but also an excitation signal component from the excitation signal generating circuit 120. Of course, in an actual circuit, the sampling resistor 130 could be replaced with a more complex sampling circuit.

The filter circuit 140 acquires a voltage signal on the sampling resistor 130, the voltage signal reflecting the size of the current flowing through the sampling resistor 130, i.e. the current sensed by the current transformer. The filter circuit 140 then subjects the voltage signal acquired to hardware filtering, to filter out the excitation signal component generated by the excitation signal generating unit 120. For example, the filter circuit 140 is a low-pass filter. An analog quantity resulting from the filtering is fed to the processing unit 150.

The processing unit 150 subjects the signal from the filter circuit 140 to A/D sampling, to obtain sample data associated with residual current, and analyses the sample data to determine whether a residual current is present. The analysis performed by the processing unit 150 may for example comprise analysing whether the amplitude of current exceeds a predetermined threshold. If the predetermined threshold is exceeded, the processing unit 150 issues an indication signal, to indicate the presence of a residual current, and thereby triggers the action of a protection mechanism.

In the example shown in Fig. 1, the excitation signal component of the sample signal is filtered out using hardware. To achieve such hardware filtering, the excitation signal generating circuit must be designed in such a way that the excitation signal frequency thereof is much higher than a normal residual current signal frequency detection range. For example, the frequency of the excitation signal usually reaches twice the maximum detectable residual current signal frequency. Thus, the high-frequency part (i.e. the excitation signal part) of the sample signal can be filtered out in the filter circuit by means of a hardware low-pass filter, to leave the residual current signal part. Finally, the analysis unit 150 subjects the filtered signal to analysis and judgment using software and algorithms.

Other devices for residual current detection are disclosed in US 2012/0319699A1, EP2395363A2, and US 5223789.

If such a design, shown in Fig. 1, is adopted, the excitation signal frequency must be much higher than the maximum detectable residual current signal frequency. As a consequence, the frequency detection range of residual current is limited by power and circuitry, and cannot attain a higher value. In addition, it is usually necessary to use a multi-stage low-pass filter,to filter out the excitation signal.

An object of the present invention is to provide a residual current detection method and device, the residual current frequency detection range of which can reach the required value, and not be limited by the choice of excitation signal frequency. Another object of the present invention is to provide a residual current detection device, which has definite advantages over the solution shown in Fig. 1 in terms of hardware cost and space.

To achieve the above objectives, the present invention presents a method for residual current detection, comprising: acquiring time domain data associated with a current flowing through a current transformer, wherein the current transformer is used for sensing residual current on a power supply line, and the time domain data includes an excitation signal component for exciting the current transformer; converting the time domain data from the time domain to the frequency domain, to obtain frequency domain data; filtering the frequency domain data in the frequency domain, to filter out frequency domain data associated with the excitation signal; analysing the filtered frequency domain data, to determine whether a residual current is present.

Preferably, the frequency of the excitation signal is close to and spaced apart from a frequency spectrum detection range detectable by the current transformer, or the frequency of the excitation signal overlaps with the frequency spectrum detection range.

Preferably, the step of converting from the time domain to the frequency domain employs fast Fourier transform. Even more preferably, the step of converting from the time domain to the frequency domain employs base 2 or base 4 fast Fourier transform. Optionally, different windowing lengths are used for a low-frequency part and a high-frequency part in the fast Fourier transform algorithm. Preferably, the windowing length for the high-frequency part in the fast Fourier transform algorithm is less than or equal to 20 ms. The windowing length for the low-frequency part in the fast Fourier transform algorithm is greater than or equal to 100 ms. Optionally, the window function in the fast Fourier transform algorithm is a rectangular window function, a Hanning window function or a Hamming window function.

Optionally, the step of analysing the filtered frequency domain data comprises for example determining whether an effective value of a current amplitude reflected by frequency domain data obtained by filtering is greater than a predetermined first threshold, or determining whether a current amplitude reflected by frequency domain data obtained by filtering exceeds a predetermined second threshold.

According to one aspect of the present invention, also presented is a device for realizing the residual current detection method. The device comprises: an acquisition unit, for acquiring time domain data associated with a current flowing through a current transformer, wherein the current transformer is used for sensing residual current on a power supply line, and the time domain data includes an excitation signal component for exciting the current transformer; a conversion unit, for converting the time domain data from the time domain to the frequency domain, to obtain frequency domain data; a filtering unit, for filtering the frequency domain data in the frequency domain, to filter out the part associated with the excitation signal component; an analysis unit, for analysing the filtered frequency domain data, to determine whether a residual current is present.

According to one aspect of the present invention, also presented is a residual current protection device, comprising:
a current transformer, for sensing a current value which includes information about residual current on a power supply line; an excitation unit, for providing an excitation signal to the current transformer; a sampling unit, for subjecting the value of a current flowing through the current transformer to A/D sampling, so as to obtain time domain data; the device for residual current detection described above, which is coupled to the sampling unit and outputs an indication signal capable of indicating whether a residual current is present.

The above method and device set forth in the present invention employ a frequency spectrum analysis method. Compared to methods relying on a hardware filter, the spectrum analysis method does not require the excitation signal frequency to be much higher than the frequency detection range of residual current. In fact, a reasonable value may be chosen for the frequency of the excitation signal according to actual needs, so that the excitation signal generating circuit has a simple structure and is easy to implement, with low power consumption and costs. Secondly, in the spectrum analysis method, the voltage signal on the sampling resistor is read directly and subjected to A/D sampling, followed by filtering by software algorithm, so that there is no longer a need for a hardware filter circuit, bringing further savings in terms of hardware cost and space. Furthermore, owing to the strong expandability of the spectrum analysis method, the effective value, frequency and even type of the current signal may be analysed and determined by algorithm. Thus, residual current detection functionality can be enhanced by adopting the method and device of the present invention.

The accompanying drawings below are merely intended to illustrate and explain the present invention schematically, without defining the scope thereof.
Fig. 1 shows a structural block diagram of an existing residual current detection device;
Fig. 2 shows a structural block diagram of a residual current detection device according to an embodiment of the present invention;
Fig. 3 shows a flow chart of the residual current detection method according to an embodiment of the present invention;
Fig. 4 shows a structural block diagram of a processing device for detecting whether a residual current is present according to an embodiment of the present invention.

### List of reference labels

- 110: inductor;
- 120: excitation signal generating circuit;
- 130: sampling resistor
- 140: filter circuit
- 150: processor
- 260: A/D sampling unit;
- 250: processing unit
- 410: acquisition unit
- 420: conversion unit
- 430: frequency spectrum filtering unit
- 440: analysis unit

Fig. 2 shows schematically a residual current detection device 200 according to an embodiment of the present invention. Unlike Fig. 1, the device 200 shown in Fig. 2 no longer comprises a hardware filter circuit 140; this is replaced by frequency spectrum filtering, realized by a processing unit 250. To be specific, as Fig. 2 shows, an A/D sampling circuit (analog/digital sampling circuit) 260 samples a voltage on a sampling resistor 130, and converts the sampled voltage signal to a digital signal, forming time domain data which is then fed to the processing unit 250. The time domain data is processed in the,processing unit 250. Optionally, if the processing unit 250 itself has an A/D port, the processing unit 250 may be directly coupled to the top end of the sampling resistor 130. Depending on actual requirements, the sampling resistor 130 may be replaced by another more complex sampling circuit. Alternatively, the A/D sampling circuit 260 may be realized by any suitable A/D conversion device.

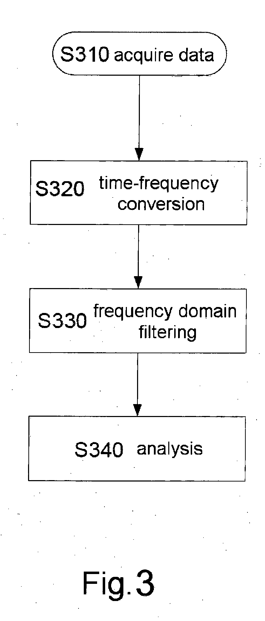

Fig. 3 shows by way of example a detection method executed by the processing unit 250 according to an embodiment of the present invention. To be specific, as Fig. 3 shows, the steps begin with S310. In step S310, the processing unit 250 acquires from the A/D sampling unit 260 time domain data corresponding to a current flowing through the current transformer. In step S320, the processing unit 250 converts the time domain data acquired from the time domain to the frequency domain, to obtain frequency domain data. Preferably, the processing unit 250 may use fast Fourier transform to achieve the time-frequency conversion in step S320. Various fast Fourier transform methods may be used for the fast Fourier transform in the time-frequency conversion step S320. For example, the conversion step 320 may use base 2 or base 4 fast Fourier transform. This enables the number of operations in the fast Fourier transform to be reduced. Preferably, the windowing length in the fast Fourier transform algorithm may also be selectively determined according to actual requirements. For example, different windowing lengths may be used for a low-frequency part and a high-frequency part. For instance, the windowing length for the low-frequency part is smaller than the windowing length for the high-frequency part. For example, the windowing length for the high-frequency part in the fast Fourier transform algorithm is less than or equal to 20 ms. The windowing length for the low-frequency part in the fast Fourier transform algorithm is greater than or equal to 100 ms. Furthermore, optionally, the window function in the fast Fourier transform algorithm may be any one of a rectangular window function, a Hanning window function and a Hamming window function.

Once time-frequency conversion is complete, in step S330, the processing unit 250 filters the frequency domain data in the frequency domain, to filter out the frequency spectrum component of the excitation signal, and leave the frequency spectrum component associated with residual current. Those skilled in the art can understand that the filtering method used in step S330 may be any existing frequency spectrum filtering method.

In step S340, the processing unit 250 analyses the frequency spectrum data obtained by filtering, to determine whether a residual current is present. For example, the processing unit 250 may obtain an effective value of current amplitude based on the frequency domain data obtained by filtering, and determine whether this effective value is greater than a predetermined first threshold; if it is greater, this indicates that a residual current has arisen. Alternatively, the processing unit 250 may obtain an amplitude of current data based on the frequency domain data obtained by filtering, and determine whether this amplitude exceeds a predetermined second threshold; if it does, this indicates that a residual current has arisen. If it is determined in step S340 that a residual current is present, the processing unit 250 issues an indication signal, to indicate the presence of a residual current. The indication signal will be used to trigger the action of a protection mechanism, to break the relevant power supply connection. Since the analysis operation in step S340 is performed on frequency spectrum data, the frequency spectrum analysis method thereof is highly expandable. For example, in step S340, the processing unit may also analyse the frequency of a current signal reflected by the frequency spectrum data, and even determine by means of analysis the type of residual current signal accordingly.

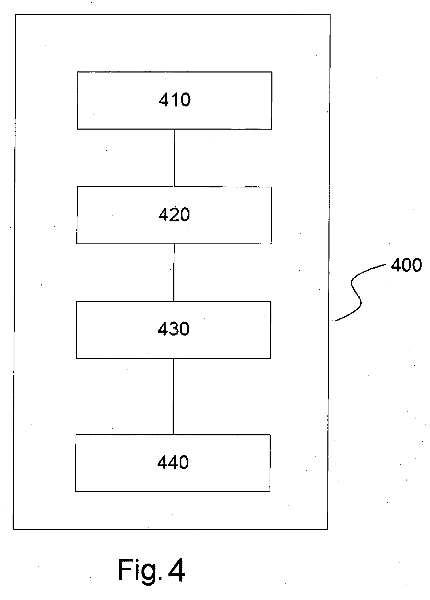

Fig. 4 shows a structural block diagram of a processing device 400 for detecting whether a residual current is present according to an embodiment of the present invention. Here, the processing unit 400 may be a computing device consisting of a processor or a memory, etc., on which software may be run to realize the method shown in Fig. 3. Alternatively, the processing unit 400 may be a hardware unit capable of realizing the functions of each of the steps shown in Fig. 3, for example a programmable logic array, a DSP or an embedded system, etc. Fig. 4 merely shows by way of example the structure of the processing unit 400. Depending on the actual circumstances, the different units included in the processing unit 400 shown in Fig. 4 could also be combined with each other, or further divided according to their function; this is obvious to those skilled in the art.

The residual current detection device 400 shown in Fig. 4 comprises an acquisition unit 410, a conversion unit 420, a frequency spectrum filtering unit 430 and an analysis unit 440. The acquisition unit 410 is used for acquiring time domain data associated with current flowing through a current transformer, wherein the current transformer is used for sensing residual current on a power supply line, and the time domain data includes an excitation signal component for exciting the current transformer. The conversion unit 420 converts the time domain data from the time domain to the frequency domain, to obtain frequency domain data. The frequency spectrum filtering unit 430 is used for filtering the frequency domain data in the frequency domain, to filter out frequency domain data associated with the excitation signal component. The analysis unit 440 is used for analysing the filtered frequency domain data, to determine whether a residual current is present. If it is discovered in this determining step that a residual current is present, the analysis unit 440 issues an indication signal, to trigger the action of a protecting mechanism, and thereby break the relevant power supply connection.

The above method and device set forth in the present invention employ a frequency spectrum analysis method. Compared to methods relying on a hardware filter, the spectrum analysis method does not require the excitation signal frequency to be much higher than the frequency detection range of residual current. In fact, a reasonable value may be chosen for the frequency of the excitation signal according to actual needs, so that the excitation signal generating circuit has a simple structure and is easy to implement, with low power consumption and costs. Secondly, in the spectrum analysis method, the voltage signal on the sampling resistor is read directly and subjected to A/D sampling, followed by filtering by software algorithm, so that there is no longer a need for a hardware filter circuit, bringing further savings in terms of hardware cost and space. Furthermore, owing to the strong expandability of the spectrum analysis method, the effective value, frequency and even type of the current signal may be analysed and determined by algorithm. Thus, residual current detection functionality can be enhanced by adopting the method and device of the present invention.

It should be understood that although the description herein is based on various embodiments, it is certainly not the case that each embodiment includes just one independent technical solution. This method of presentation is adopted herein solely for the sake of clarity. Those skilled in the art should consider the Description in its entirety. The technical solutions in the various embodiments may also be suitably combined to form other embodiments which can be understood by those skilled in the art.

The above embodiments are merely particular schematic embodiments of the present invention, and are by no means intended to define the scope thereof. Any equivalent changes, amendments or combinations made by those skilled in the art without deviating from the concept and principle of the present invention should be included in the scope of protection thereof.

## Claims

1. A method for residual current detection, comprising:
acquiring time domain data associated with a current flowing through a current transformer, wherein the current transformer is used for sensing residual current on a power supply line, and the time domain data includes an excitation signal component for exciting the current transformer;
converting the time domain data from the time domain to the frequency domain, to obtain frequency domain data;
filtering the frequency domain data in the frequency domain, to filter out frequency domain data associated with the excitation signal component;
analysing the filtered frequency domain data, to determine whether a residual current is present.

2. The method as claimed in claim 1, wherein the frequency of the excitation signal is close to and spaced apart from a frequency spectrum detection range of the residual current, or the frequency of the excitation signal overlaps with the frequency spectrum detection range of the residual current.

3. The method as claimed in claim 2, wherein the step of converting from the time domain to the frequency domain employs fast Fourier transform.

4. The method as claimed in claim 3, wherein the step of converting from the time domain to the frequency domain employs base 2 or base 4 fast Fourier transform.

5. The method as claimed in claim 3 or 4, wherein different windowing lengths are used for a low-frequency part and a high-frequency part in the fast Fourier transform algorithm.

6. The method as claimed in claim 5, wherein the windowing length for the high-frequency part is less than or equal to 20 ms.

7. The method as claimed in claim 5, wherein the windowing length for the low-frequency part is greater than or equal to 100 ms.

8. The method as claimed in claim 5, wherein the window function in the fast Fourier transform algorithm is a rectangular window function, a Hanning window function or a Hamming window function.

9. The method as claimed in claim 1, wherein the step of analysing the filtered frequency domain data comprises:
if an effective value of a current amplitude reflected by the filtered frequency domain data is greater than a predetermined first threshold, indicating that a residual current is present; or
if a current amplitude reflected by the filtered frequency domain data exceeds a predetermined second threshold, indicating that a residual current is present.

10. A device for residual current detection, comprising:
an acquisition unit (410), for acquiring time domain data associated with a current flowing through a current transformer, wherein the current transformer is used for sensing residual current on a power supply line, and the time domain data includes an excitation signal component for exciting the current transformer;
a conversion unit (420), for converting the time domain data from the time domain to the frequency domain, to obtain frequency domain data;
a frequency spectrum filtering unit (430), for filtering the frequency domain data in the frequency domain, to filter out frequency domain data associated with the excitation signal component;
an analysis unit (440), for analysing the filtered frequency domain data, to determine whether a residual current is present.

11. The device as claimed in claim 10, wherein the frequency of the excitation signal is close to and spaced apart from a frequency spectrum detection range of the residual current, or the frequency of the excitation signal overlaps with the frequency spectrum detection range of the residual current.

12. The device as claimed in claim 11, wherein the conversion unit (420) performs a fast Fourier transform on the time domain data.

13. The device as claimed in claim 12, wherein different windowing lengths are used for a low-frequency part and a high-frequency part in the fast Fourier transform algorithm.

14. The device as claimed in claim 13, wherein the window function in the fast Fourier transform algorithm is a rectangular window function, a Hanning window function or a Hamming window function.

15. The device as claimed in claim 10, wherein
upon determining that an effective value of a current amplitude reflected by the filtered frequency domain data is greater than a predetermined first threshold, the analysis unit outputs an indication signal to indicate that a residual current is present; or
upon determining that a current amplitude reflected by the filtered frequency domain data exceeds a predetermined second threshold, the analysis unit outputs an indication signal to indicate that a residual current is present.

16. A residual current protection device, comprising:
a current transformer (110), for sensing a current value which includes information about residual current on a power supply line;
a sampling unit (260), for subjecting a current value from the current transformer to A/D sampling, so as to obtain time domain data;
the device for residual current detection as claimed in any one of claims 10 - 15, which is coupled to the sampling unit and outputs an indication signal capable of indicating whether a residual current is present.

## Patentansprüche

1. Verfahren zur Reststromdetektion, das Folgendes umfasst:
Erfassen von Zeitbereichsdaten, die einem Strom zugeordnet sind, der durch einen Stromwandler fließt, wobei der Stromwandler verwendet wird, um einen Reststrom in einer Stromversorgungsleitung zu erfassen, und wobei die Zeitbereichsdaten eine Erregungssignalkomponente zum Erregen des Stromwandlers enthalten;
Umsetzen der Zeitbereichsdaten vom Zeitbereich in den Frequenzbereich, um Frequenzbereichsdaten zu erhalten;
Filtern der Frequenzbereichsdaten im Frequenzbereich, um Frequenzbereichsdaten, die der Erregungssignalkomponente zugeordnet sind, herauszufiltern;
Analysieren der gefilterten Frequenzbereichsdaten, um zu bestimmen, ob ein Reststrom vorhanden ist.

2. Verfahren nach Anspruch 1, wobei die Frequenz des Erregungssignals in der Nähe eines Frequenzspektrum-Detektionsbereichs des Reststroms liegt und hiervon beabstandet ist oder wobei die Frequenz des Erregungssignals mit dem Frequenzspektrum-Detektionsbereich des Reststroms überlappt.

3. Verfahren nach Anspruch 2, wobei der Schritt des Umsetzens vom Zeitbereich in den Frequenzbereich eine schnelle Fourier-Transformation verwendet.

4. Verfahren nach Anspruch 3, wobei der Schritt des Umsetzens vom Zeitbereich in den Frequenzbereich eine schnelle Fourier-Transformation auf Basis 2 oder Basis 4 verwendet.

5. Verfahren nach Anspruch 3 oder 4, wobei in dem Algorithmus für schnelle Fourier-Transformation unterschiedliche Fensterbildungslängen für einen niederfrequenten Teil und einen hochfrequenten Teil verwendet werden.

6. Verfahren nach Anspruch 5, wobei die Fensterbildungslänge für den hochfrequenten Teil kleiner oder gleich 20 ms ist.

7. Verfahren nach Anspruch 5, wobei die Fensterbildungslänge für den niederfrequenten Teil größer oder gleich 100 ms ist.

8. Verfahren nach Anspruch 5, wobei die Fensterfunktion in dem Algorithmus für schnelle Fourier-Transformation eine Rechteckfensterfunktion, eine Hanning-Fensterfunktion oder eine Hamming-Fensterfunktion ist.

9. Verfahren nach Anspruch 1, wobei der Schritt des Analysierens der gefilterten Frequenzbereichsdaten Folgendes umfasst:
falls ein Effektivwert einer Stromamplitude, die durch die gefilterten Frequenzbereichsdaten reflektiert wird, größer als ein vorgegebener erster Schwellenwert ist, Angeben, dass ein Reststrom vorhanden ist; oder
falls eine Stromamplitude, die durch die gefilterten Frequenzbereichsdaten reflektiert wird, einen vorgegebenen zweiten Schwellenwert überschreitet, Angeben, dass ein Reststrom vorhanden ist.

10. Vorrichtung zur Reststromdetektion, die Folgendes umfasst:
eine Erfassungseinheit (410) zum Erfassen von Zeitbereichsdaten, die einem Strom zugeordnet sind, der durch einen Stromwandler fließt, wobei der Stromwandler verwendet wird, um einen Reststrom in einer Stromversorgungsleitung zu erfassen, und die Zeitbereichsdaten eine Erregungssignalkomponente zum Erregen des Stromwandlers enthalten;
eine Umsetzungseinheit (420) zum Umsetzen der Zeitbereichsdaten vom Zeitbereich in den Frequenzbereich, um Frequenzbereichsdaten zu erhalten;
eine Frequenzspektrum-Filterungseinheit (430) zum Filtern der Frequenzbereichsdaten in dem Frequenzbereich, um Frequenzbereichsdaten, die der Erregungssignalkomponente zugeordnet sind, herauszufiltern;
eine Analyseeinheit (440) zum Analysieren der gefilterten Frequenzbereichsdaten, um zu bestimmen, ob ein Reststrom vorhanden ist.

11. Vorrichtung nach Anspruch 10, wobei die Frequenz des Erregungssignals in der Nähe eines Frequenzspektrum-Detektionsbereichs des Reststroms liegt und hiervon beabstandet ist oder wobei die Frequenz des Erregungssignals mit dem Frequenzspektrum-Detektionsbereich des Reststroms überlappt.

12. Vorrichtung nach Anspruch 11, wobei die Umsetzungseinheit (420) an den Zeitbereichsdaten eine schnelle Fourier-Transformation ausführt.

13. Vorrichtung nach Anspruch 12, wobei in dem Algorithmus für schnelle Fourier-Transformation für einen niederfrequenten Teil und einen hochfrequenten Teil unterschiedliche Fensterbildungslängen verwendet werden.

14. Vorrichtung nach Anspruch 13, wobei die Fensterfunktion in dem Algorithmus für schnelle Fourier-Transformation eine Rechteckfensterfunktion, eine Hanning-Fensterfunktion oder eine Hamming-Fensterfunktion ist.

15. Vorrichtung nach Anspruch 10, wobei
dann, wenn bestimmt wird, dass ein Effektivwert einer Stromamplitude, die durch die gefilterten Frequenzbereichsdaten reflektiert wird, größer als ein vorgegebener erster Schwellenwert ist, die Analyseeinheit ein Angabesignal ausgibt, um anzugeben, dass ein Reststrom vorhanden ist; oder
dann, wenn bestimmt wird, dass eine Stromamplitude, die durch die gefilterten Frequenzbereichsdaten reflektiert wird, einen vorgegebenen zweiten Schwellenwert überschreitet, die Analyseeinheit ein Angabesignal ausgibt, um anzugeben, dass ein Reststrom vorhanden ist.

16. Reststrom-Schutzvorrichtung, die Folgendes umfasst:
einen Stromwandler (110) zum Erfassen eines Stromwerts, der Informationen über einen Reststrom in einer Stromversorgungsleitung enthält;
eine Abtasteinheit (260), um einen Stromwert von dem Stromwandler einer A/D-Abtastung zu unterwerfen, um Zeitbereichsdaten zu erhalten;
die Vorrichtung zur Reststromdetektion nach einem der Ansprüche 10-15, die mit der Abtasteinheit gekoppelt ist und ein Angabesignal ausgibt, das angeben kann, ob ein Reststrom vorhanden ist.

## Revendications

1. Procédé de détection d'un courant résiduel, comprenant les étapes consistant à :
acquérir des données dans le domaine temporel associées à un courant circulant dans un transformateur de courant, le transformateur de courant servant à détecter un courant résiduel sur une ligne d'alimentation électrique et les données dans le domaine temporel comportant une composante de signal d'excitation destinée à exciter le transformateur de courant ;
effectuer une conversion du domaine temporel au domaine fréquentiel des données dans le domaine temporel dans le but d'obtenir des données dans le domaine fréquentiel ;
filtrer dans le domaine fréquentiel les données dans le domaine fréquentiel dans le but d'extraire par filtrage des données dans le domaine fréquentiel associées à la composante de signal d'excitation ;
analyser les données dans le domaine fréquentiel filtrées dans le but d'établir si un courant résiduel est présent.

2. Procédé selon la revendication 1, dans lequel la fréquence du signal d'excitation est proche et espacée d'une plage de détection de spectre de fréquences du courant résiduel, ou la fréquence du signal d'excitation chevauche la plage de détection de spectre de fréquences du courant résiduel.

3. Procédé selon la revendication 2, dans lequel l'étape consistant à effectuer une conversion du domaine temporel au domaine fréquentiel fait appel à une transformation de Fourier rapide.

4. Procédé selon la revendication 3, dans lequel l'étape consistant à effectuer une conversion du domaine temporel au domaine fréquentiel fait appel à une transformation de Fourier rapide en base 2 ou en base 4.

5. Procédé selon la revendication 3 ou 4, dans lequel des longueurs de fenêtrage différentes sont utilisées pour une partie basse fréquence et une partie haute fréquence dans l'algorithme de transformation de Fourier rapide.

6. Procédé selon la revendication 5, dans lequel la longueur de fenêtrage pour la partie haute fréquence est inférieure ou égale à 20 ms.

7. Procédé selon la revendication 5, dans lequel la longueur de fenêtrage pour la partie basse fréquence est supérieure ou égale à 100 ms.

8. Procédé selon la revendication 5, dans lequel la fonction fenêtre dans l'algorithme de transformation de Fourier rapide est une fonction fenêtre rectangulaire, une fonction fenêtre de Hanning ou une fonction fenêtre de Hamming.

9. Procédé selon la revendication 1, dans lequel l'étape consistant à analyser les données dans le domaine fréquentiel filtrées comprend les étapes consistant à :
si une valeur efficace d'une amplitude de courant exprimée par les données dans le domaine fréquentiel filtrées est supérieure à un premier seuil préétabli, indiquer qu'un courant résiduel est présent ; ou
si une amplitude de courant exprimée par les données dans le domaine fréquentiel filtrées dépasse un deuxième seuil préétabli, indiquer qu'un courant résiduel est présent.

10. Dispositif de détection d'un courant résiduel, comprenant :
une unité d'acquisition (410), destinée à acquérir des données dans le domaine temporel associées à un courant circulant dans un transformateur de courant, le transformateur de courant servant à détecter un courant résiduel sur une ligne d'alimentation électrique et les données dans le domaine temporel comportant une composante de signal d'excitation destinée à exciter le transformateur de courant ;
une unité de conversion (420), destinée à effectuer une conversion du domaine temporel au domaine fréquentiel des données dans le domaine temporel dans le but d'obtenir des données dans le domaine fréquentiel ;
une unité de filtrage de spectre de fréquences (430), destinée à filtrer dans le domaine fréquentiel les données dans le domaine fréquentiel dans le but d'extraire par filtrage des données dans le domaine fréquentiel associées à la composante de signal d'excitation ;
une unité d'analyse (440), destinée à analyser les données dans le domaine fréquentiel filtrées dans le but d'établir si un courant résiduel est présent.

11. Dispositif selon la revendication 10, dans lequel la fréquence du signal d'excitation est proche et espacée d'une plage de détection de spectre de fréquences du courant résiduel, ou la fréquence du signal d'excitation chevauche la plage de détection de spectre de fréquences du courant résiduel.

12. Dispositif selon la revendication 11, dans lequel l'unité de conversion (420) soumet les données dans le domaine temporel à une transformation de Fourier rapide.

13. Dispositif selon la revendication 12, dans lequel des longueurs de fenêtrage différentes sont utilisées pour une partie basse fréquence et une partie haute fréquence dans l'algorithme de transformation de Fourier rapide.

14. Dispositif selon la revendication 13, dans lequel la fonction fenêtre dans l'algorithme de transformation de Fourier rapide est une fonction fenêtre rectangulaire, une fonction fenêtre de Hanning ou une fonction fenêtre de Hamming.

15. Dispositif selon la revendication 10, dans lequel
s'il est établi qu'une valeur efficace d'une amplitude de courant exprimée par les données dans le domaine fréquentiel filtrées est supérieure à un premier seuil préétabli, l'unité d'analyse fournit un signal d'indication pour indiquer qu'un courant résiduel est présent ; ou
s'il est établi qu'une amplitude de courant exprimée par les données dans le domaine fréquentiel filtrées dépasse un deuxième seuil préétabli, l'unité d'analyse fournit un signal d'indication pour indiquer qu'un courant résiduel est présent.

16. Dispositif de protection contre un courant résiduel, comprenant :
un transformateur de courant (110), destiné à détecter une valeur de courant comportant des informations sur un courant résiduel sur une ligne d'alimentation électrique ;
une unité d'échantillonnage (260), destinée à soumettre une valeur de courant issue du transformateur de courant à un échantillonnage analogique/numérique de façon à obtenir des données dans le domaine temporel ;
le dispositif de détection d'un courant résiduel selon l'une quelconque des revendications 10 à 15, relié à l'unité d'échantillonnage et fournissant un signal d'indication apte à indiquer si un courant résiduel est présent.
